# EUROPEAN PATENT APPLICATION

(11) **EP 2 741 210 A1**
(43) Date of publication of application: **11.06.2014**
(21) Application number: 13195790.4
(22) Date of filing: 05.12.2013
(51) Int. Cl.: G06F 11/07

(54) **Systems and methods for fault detection**

(30) Priority: 10.12.2012 US 201213709928
(71) Applicant: General Electric Company, Schenectady, New York 12345 (US)
(72) Inventor: Alley, Daniel Milton, Salem, VA Virginia 24153 (US); Wise, Michael G., Salem, VA Virginia 24153 (US); Mathason, Alan, Philadelphia, PA Pennsylvania 19130 (US); Boettner, Fred Henry, Salem, VA Virginia 24153 (US); Douthit, Stephen Emerson, Charlottesville, VA Virginia 22911 (US); Reed, Richard, Charlottesville, VA Virginia 22911 (US)
(74) Representative: Picker, Madeline Margaret

(57) **Abstract**

Systems, methods, and computer-readable media for fault detection are disclosed. At least one controller 110 may identify a plurality of values where each value corresponds to a monitored parameter or a measured parameter. The at least one controller 110 may determine a respective deviation between each of the plurality of values and an expected value, and may further determine whether at least one of the respective deviations exceeds a threshold. Upon a determination that at least one of the respective deviations exceeds the threshold, a fault may be detected. Each of the plurality of values may be associated with a respective device 103 that monitors or measures the value. A detected fault may be associated with the device 103 that monitors or measures the value determined to deviate from the expected value by more than the threshold.

## Description

Embodiments of the disclosure relate generally to fault detection, and more particularly, to systems and methods for fault detection.

Various systems and methodologies for fault detection are known. For example, various forms of redundancy may be employed as part of a fault tolerant design to improve the reliability and availability of a system.

For example, standby redundancy - also known as backup redundancy - is a form of redundancy in which a secondary unit is provided as a backup to a primary unit. The secondary unit typically does not monitor the system, but is maintained in sync with the primary unit to allow the secondary unit to assume control in the event of a failure of the primary unit. A voting unit is generally provided to determine when a switchover condition is met for switching control from the primary unit to the secondary unit.

Another form of redundancy known as N-modular redundancy can involve the parallel operation of multiple units that are synchronized and receive the same input information. Output information generated by the multiple units operating in parallel may be compared by a voting system to determine if any of the output information is representative of a failure of one or more units.

Numerous other forms of redundancy are known as well. For example, 1:N redundancy is a form of redundant design in which a single unit serves as a backup for multiple primary units. The backup unit is generally capable of providing the functionality provided by any of the primary units. This form of redundancy is generally more cost-effective than other forms of redundancy but is typically only feasible in scenarios in which the primary units serve similar functions.

According to one or more embodiments of the disclosure, a method is disclosed. The method may be performed upon execution of computer-executable instructions stored in at least one memory by at least one controller that may include one or more processors. The method may include: i) identifying a plurality of values, where each of the plurality of values corresponds to a respective one of: a monitored parameter or a measured parameter, ii) determining a respective deviation between each of the plurality of values and an expected value, iii) determining that at least one of the respective deviations exceeds a threshold, and iv) detecting a fault based at least in part on the determination that at least one of the respective deviations exceeds the threshold.

According to one or more additional embodiments of the disclosure, a system is disclosed. The system may include at least one memory storing computer-executable instructions, at least one controller, and a plurality of devices. The at least one controller may be configured to access the at least one memory and to execute the computer-executable instructions to: i) identify a plurality of values, where each of the plurality of values is monitored or measured by a respective device of the plurality of devices, and where each of the plurality of values is associated with a respective one of: a monitored parameter or a measured parameter, ii) determine a respective deviation between each of the plurality of values and an expected value, iii) determine that at least one of the respective deviations exceeds a threshold, and iv) detect a fault based at least in part on the determination that at least one of the respective deviations exceeds the threshold.

According to one or more additional embodiments of the disclosure, one or more computer-readable media are disclosed. The one or more computer-readable media may store computer-executable instructions that upon execution by one or more processors configure the one or more processors to perform operations comprising: i) identifying a plurality of values, where each of the plurality of values corresponds to a respective one of: a monitored parameter or a measured parameter, ii) determining a respective deviation between each of the plurality of values and an expected value, iii) determining that at least one of the respective deviations exceeds a threshold, and iv) detecting a fault based at least in part on the determination that at least one of the respective deviations exceeds the threshold.

Other embodiments of the disclosure will be apparent from the following detailed description, the accompanying drawings, and the appended claims.

The detailed description is set forth through reference to the accompanying drawings, which are not necessarily drawn to scale. A brief description of each drawing is provided below. In the drawings, same reference numerals indicate similar or identical elements; however, different reference numerals may be used to indicate similar or identical elements as well.
FIG. 1 is a schematic block diagram depicting an illustrative architecture for fault detection in which multiple monitoring/control devices are communicatively coupled to a processing unit via a shared communication path in accordance with one or more embodiments of the disclosure.
FIG. 2 is a schematic block diagram depicting an illustrative architecture for fault detection in which each of multiple monitoring/control devices is communicatively coupled to a respective processing unit via a respective separate communication path in accordance with one or more embodiments of the disclosure.
FIGS. 3A-3H are schematic block diagrams illustrating various operational modes that may be assigned to channels of monitoring/control devices in accordance with one or more embodiments of the disclosure.
FIG. 4 is a detailed schematic block diagram depicting components of an illustrative monitoring/control device in accordance with one or more embodiments of the disclosure.
FIG. 5 is a schematic block diagram depicting an illustrative architecture for fault detection in accordance with one or more additional embodiments of the disclosure.
FIG. 6 is a process flow diagram depicting an illustrative method for fault detection in accordance with one or more embodiments of the disclosure.

Illustrative embodiments of the disclosure relate to, among other things, systems, methods, and computer-readable media for fault detection. Multiple monitoring/control devices may be provided for monitoring and/or controlling various parameters. Multiple input/output communication paths may be provided for transmitting signals received from a circuitry block to one or more of the multiple monitoring/control devices and/or for transmitting signals to the circuitry block from one or more of the multiple monitoring/control devices. The circuitry block may be associated with any of a variety of types of equipment having operational parameters that are monitored or controlled by the monitoring/control devices. For example, the circuitry block may be associated with one or more sensors that sense various parameters associated with the operation of equipment. As another non-limiting example, the circuitry block may be associated with a load having operating parameters that may be controlled by the monitoring/control devices.

The monitoring/control devices may be communicatively coupled to at least one processing unit. In certain embodiments, each of the monitoring/control devices may be communicatively coupled to the same processing unit via at least one shared communication path. In various embodiments, signals received from the processing unit may be transmitted to each of the monitoring/control devices via shared communication paths. For example, the monitoring/control devices may be daisy-chained such that signals that are representative of values monitored by the monitoring/control devices may be transmitted sequentially between the devices and to the processing unit.

In other embodiments, each of the monitoring/control devices may be communicatively coupled to a respective processing unit via a respective separate communication path. Each of the processing units may be provided on a separate processor board. Alternatively or additionally, multiple processing units may be provided on a same processor board. An architecture in which each of the monitoring/control devices is communicatively coupled to a different respective processing unit may provide greater redundancy than the previously described architecture in which each monitoring/control device is communicatively coupled to a same processing unit. Accordingly, if any one of the processing units was to fail and/or any one of the monitoring/control devices was to fail, the redundancy provided by the other processing units and/or the other monitoring/control devices may be relied on for continued operation. The desired level of redundancy (e.g., multiple monitoring/control devices communicatively coupled to a single processing unit, multiple monitoring/control devices each communicatively coupled to a respective processing unit, etc.) can involve a tradeoff between a desired fault coverage, odds of failure of a particular type of device (e.g., the processing unit may be inherently more reliable than the monitoring/control device), a desired detectability, and so forth.

As previously noted, multiple input/output communication paths may be provided that allow for analog signals to be communicated between the monitoring/control devices and circuitry associated with equipment. The circuitry may be associated with one or more sensors that detect various operational parameters of equipment, a control system that controls various operational parameters of equipment, and so forth. A same set of input/output communication paths may be connected to each of the monitoring/control devices such that the monitoring/control devices are connected in parallel. Signals may be received by each of the parallel connected monitoring/control devices from the circuitry via one or more of the input/output communication paths. In certain embodiments, one or more parameters (e.g., a voltage, current, thermocouple, etc.) may be monitored or sensed by each of the monitoring/control devices. The monitored or sensed parameter values may be communicated to one or more processing units depending on the particular architecture employed. The processing unit(s) may analyze the received values to determine if any of the values deviate from an expected value by more than a threshold amount.

In those embodiments in which the number of monitoring/control devices is greater than two, the median (or average) of values received from the monitoring/control devices may be used by the processing unit(s) as the expected value. In those embodiments in which two monitoring/control devices are provided (e.g., a master/slave configuration), the expected value may be determined based at least in part on historical values received from the monitoring/control devices. If a particular received value deviates from an expected value (which may be determined based on historical values) by more than a specified threshold, the processing unit(s) may determine that a fault has occurred. The fault may be determined to be associated with the monitoring/control device from which the particular value was received. If a fault is determined to exist, the corresponding monitoring/control device may be disconnected from the architecture and the remaining monitoring/control devices may be relied on for further operation.

In certain embodiments, settings corresponding to various parameter values (e.g., voltage, current, etc.) may be provided to the monitoring/control devices by the processing unit(s). These parameter values may, in turn, be supplied via the input/output communication paths to circuitry associated with equipment in order to measure, monitor, or control operational parameters of the equipment. These other measured or monitored values may then be communicated by the monitoring/control devices to the processing unit(s).

In one or more embodiments of the disclosure, each of the monitoring/control devices may comprise a respective application-specific integrated circuit (ASIC). While the following discussion of channels and channel assignments may be presented in the context of ASIC devices, and while various embodiments of the disclosure may be described in the context of ASIC devices, it should be appreciated that embodiments of the disclosure are applicable to any monitoring/control device capable of providing similar functionality.

The parameters that are measured or monitored by an ASIC in accordance with one or more embodiments of the disclosure may be determined based on various operational modes assigned to channels of the ASIC. Each ASIC may include, for example, two or more channels. However, it should be appreciated that, in certain embodiments, one or more ASICs may include a single channel. In an illustrative embodiment, at least one ASIC may include two channels. Each channel may be assigned a respective corresponding operational mode. Various combinations of operational modes may be assigned to the channels of each ASIC. For example, for a particular ASIC, a voltage setting may be applied to a first channel of the ASIC and a current setting may be applied to a second channel. Each of the voltage setting and the current setting may be transmitted via one or more respective input/output communication paths to, for example, drive a respective load (e.g., an actuator that controls one or more operational functions of equipment).

In other embodiments, other operational modes may be assigned to the channels of an ASIC. For example, a first channel of an ASIC may have its operational mode set to sense or monitor a voltage input while a second channel of an ASIC may have its operational mode set to sense or monitor a current input. In such an illustrative embodiment, the first channel of the ASIC may measure an input voltage while the second channel of the ASIC may measure an input current.

Further, a different respective operational mode corresponding to either a parameter setting or a parameter to be sensed may be assigned to each channel of a same ASIC. For example, a first channel of an ASIC may have its operational mode set to sense or monitor a voltage input while a current setting may be applied to a second channel of the same ASIC. In still other embodiments, a first channel of an ASIC may have its operational mode set to sense or monitor a voltage input while a second channel of the same ASIC may have its operational mode set to sense or monitor a current input such that an unknown resistance may be measured across a resistive element using a pair of input/output communication paths. Various configurations are possible in which two or more of the input/output communication paths are used to measure the unknown resistance. In various embodiments, the measured resistance may demonstrate a proportional behavior with another parameter (e.g., temperature).

It should be appreciated that numerous other configurations involving a variety of respective operational modes assigned to channels of an ASIC are within the scope of this disclosure. Further, operational modes assigned to channels of various ASICs may be changed if, for example, a fault condition is detected and one or more ASICs are no longer suitable for use.

Each ASIC may be connected in parallel via the input/output communication paths. Further, each ASIC may include various internal components that form part of or are otherwise associated with one or more channels of the ASIC. For example, each ASIC (or more specifically each channel of each ASIC) may have associated therewith a resistive element (e.g., a burden resistor) that may be utilized for sensing various parameters such as input current. In certain embodiments, each ASIC may have one or more dedicated burden resistors associated therewith. In other embodiments, one or more burden resistors may be connected in parallel to multiple ASICs and shared across ASICs. In certain embodiments, voltage-to-current (V-to-I) driver(s), digital-to-analog converter(s) (DAC(s)), analog-to-digital converter(s) (A/D(s)), and so forth may form part of the ASIC, while in order embodiments one or more of such components may be provided externally to the ASIC.

Technical effects achieved by certain embodiments of the disclosure may include, among other things, fault detection using a parallel connection between monitoring/measuring devices that allows for universal input/output connections between the monitoring/measuring devices and circuitry of equipment having operational parameters associated therewith that are measured, monitored, or controlled by the monitoring/measuring devices, the use of ASICs to achieve fault detection using a redundant parallel connection between the ASICs, and so forth.

Illustrative embodiments of the disclosure will now be described more fully hereinafter through reference to the accompanying drawings, in which some, but not all, embodiments of the disclosure may be shown. The disclosure may be embodied in many different forms and should not be construed as being limited to the illustrative embodiments set forth herein.

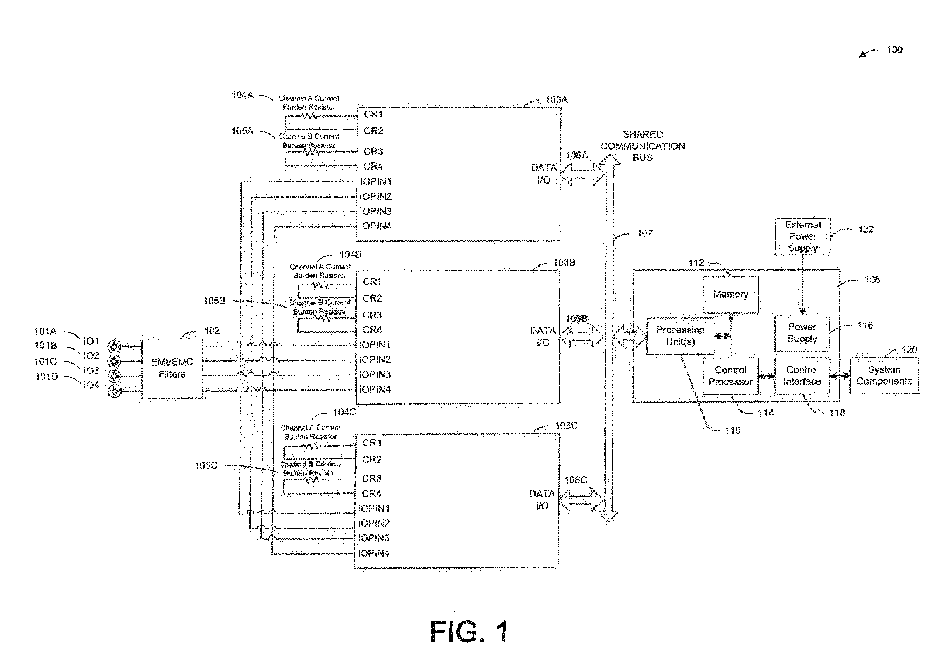

FIG. 1 is a schematic block diagram depicting an illustrative architecture 100 for fault detection in which multiple monitoring/control devices are communicatively coupled to a processing unit via a shared communication path in accordance with one or more embodiments of the disclosure.

The illustrative architecture 100 includes input/output communication paths 101A, 101B, 101C, 101D (which may be referred to hereinafter respectively as IO1, 102, 103, IO4 or collectively as IO1-IO4). While four IO communication paths are depicted it should be appreciated that any number of IO paths may be provided. The IO communication paths IO1-IO4 may allow for routing of signals between various monitoring/control devices 103A, 103B, 103C and circuitry (not depicted) that may be associated with equipment that is controlled or monitored by the monitoring/control devices 103A, 103B, 103C. For example, the circuitry may be associated with one or more sensors that detect various operational parameters of equipment, a control system that controls various operational parameters of equipment, and so forth. While three monitoring/control devices 103A, 103B, 103C are depicted, it should be appreciated that any number of such devices may be provided. Further, while the following discussion may be presented in a context in which the monitoring/control devices 103A, 103B, 103C represent ASIC devices, it should be appreciated that embodiments of the disclosure are not limited to ASICs and that any suitable monitoring/control device capable of supporting functionality described herein is within the scope of this disclosure.

The IO communication paths IO1-IO4 may be connected to each of the ASICs 103A, 103B, 103C such that the ASICs are connected in parallel. Electromagnetic interference (EMI) and/or electromagnetic compatibility (EMC) filter(s) 102 may be provided to reduce or eliminate interference or noise from signals transmitted along the IO communication paths IO1-IO4. Signals may be received by each of the parallel connected ASICs 103A, 103B, 103C on one or more of the IO communication paths IO1-IO4. In various embodiments, the signals may be representative of one or more parameters or may be otherwise utilized to monitor or measure one or more parameters such as, for example, a voltage, a current, a resistance, a thermocouple, and so forth.

The monitored or sensed parameter values may be communicated to one or more processing units 110 via a shared communication path 107. The processing unit(s) 110 may include any suitable processor including, but not limited to, a central processing unit, a microprocessor, a Reduced Instruction Set Computer (RISC) microprocessor, a microcontroller, an FPGA, a system on a chip (SOC), and forth. The processing unit(s) 110 may include any suitable processing unit capable of accepting digital data as input, processing the input data based on stored computer-executable instructions, and generating output data. The processing unit(s) 110 may be configured to execute computer-executable instructions stored in one or more memories to cause various operations to be performed. As will be described in more detail hereinafter, the processing unit(s) 110 may analyze values corresponding to parameters measured, monitored, or sensed by the ASIC devices 103A, 103B, 103C to determine if any of the values deviate from an expected value by more than a threshold amount.

In certain embodiments, the ASICs 103A, 103B, 103C may each be communicatively coupled to the same processing unit(s) 110 via respective communication paths 106A, 106B, 106C. For example, each communication path 106A, 106B, 106C may be communicatively coupled to a respective isolation barrier (not shown) which may, in turn, route signals via communication path 107 between the processing unit(s) 110 and a respective ASIC. For example, a clock signal, a select signal, a master-out slave-in (MOSI) signal, and so forth may be routed from the processing unit(s) 110 to each ASIC via a respective isolation barrier. Similarly, a master-in slave-out (MISO) signal may be communicated from an ASIC to the processing unit(s) 110 via a respective isolation barrier. In other embodiments, signals may be communicated between the processing unit(s) 110 and multiple ASICs via a shared isolation barrier. For example, a clock signal, a select signal, a MOSI signal, and so forth may be communicated from the processing unit(s) 110 to each ASIC via a shared isolation barrier. Signals may also be communicated from the ASICs to the processing unit(s) 110 (e.g., a MISO signal) via a shared isolation barrier by daisy-chaining the ASICs. It should be appreciated that numerous other configurations for communicatively coupling the ASICs 103A, 103B, 103C and the processing unit(s) 110 are within the scope of this disclosure.

The processing unit(s) 110 may be provided on a processor board 108 which may include other components such as one or more memories 112, a control processor 114, an internal power supply 116, and/or a control interface 118. The one or more memories (hereinafter generically referred to as memory 112) may store program instructions that are loadable and executable by the processing unit(s) 110 as well as data manipulated and generated by the processing unit(s) 110 during execution of the program instructions. The memory 112 may include volatile memory (memory that is not configured to retain stored information when not supplied with power) such as random access memory (RAM) and/or non-volatile (memory that is configured to retain stored information even when not supplied with power) such as read-only memory (ROM), flash memory, and so forth. In various implementations, the memory 112 may include multiple different types of memory, such as static random access memory (SRAM), dynamic random access memory (DRAM), unalterable ROM, and/or writeable variants of ROM such as electrically erasable programmable read-only memory (EEPROM), flash memory, and so forth.

The processing unit(s) 110, the memory 112, and the control processor 114 may be communicatively coupled via one or more communication paths such as one or more buses (not shown). The control processor 114 may be configured to facilitate storage of information in the memory 112 and/or to facilitate retrieval of information therefrom. For example, the control processor 114 may be configured to store information in the memory 112 which may be utilized by the processing unit(s) 110 to assign operational modes to various channels of the ASIC devices 103A, 103B, 103C, transmit various parameter settings to the ASIC devices 103A, 103B, 103C (e.g., voltage settings, current settings, etc.), and so forth. The control processor 114 may be communicatively coupled to the control interface 118 which may, in turn, be communicatively coupled to one or more external system components 120. The system components 120 may form part of a control system that is configured to monitor and/or control various operational parameters associated with equipment via the ASIC devices 103A, 103B, 103C. The internal power supply 116 may be configured to supply power to various components of the processor board 108 and may, in turn, receive power input from an external power supply 122.

In addition, a respective plurality of resistive elements is depicted in FIG. 1 as being associated with each ASIC device. In various embodiments, each ASIC 103A, 103B, 103C may include one or more channels that may have respective operational modes assigned thereto. In the illustrative architecture depicted in FIG. 1, each ASIC 103A, 103B, 103C may include two channels, with each channel having a corresponding resistive element associated therewith. For example, a resistive element 104A may be associated with a first channel of ASIC 103A and a resistive element 105A may be associated with a second channel of the ASIC 103A. Similarly, a resistive element 104B may be associated with a first channel of ASIC 103B and a resistive element 105B may be associated with a second channel of the ASIC 103B. In addition, a resistive element 104C may be associated with a first channel of ASIC 103C and a resistive element 105C may be associated with a second channel of the ASIC 103C. Each resistive element may be used for sensing various parameters such as input current. In certain embodiments, each ASIC 103A, 103B, 103C may have a respective one or more resistive elements associated therewith in a dedicated fashion (as shown in FIG. 1). However, in other embodiments, one or more resistive elements may be connected in parallel to multiple ASICs and shared across ASICs.

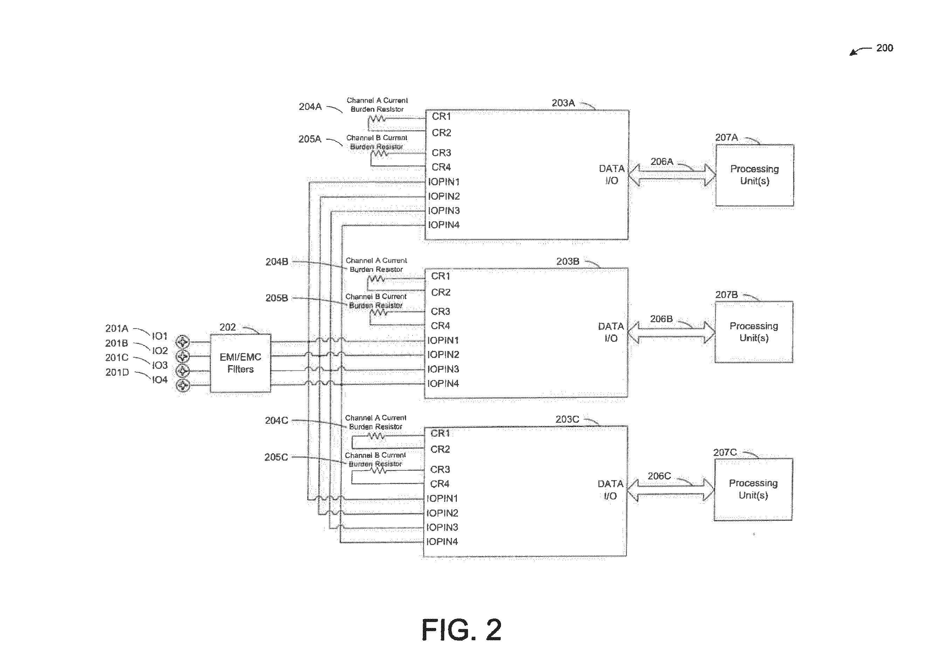

FIG. 2 is a schematic block diagram depicting an illustrative architecture 200 for fault detection in which each of multiple monitoring/control devices is communicatively coupled to a respective processing unit via a respective separate communication path in accordance with one or more alternate embodiments of the disclosure.

The illustrative architecture 200 is similar to the architecture 100 previously described in various respects. For example, the illustrative architecture 200 includes IO communication paths 201A, 201B, 201C, 201D (which may be referred to hereinafter respectively as IO1, IO2, IO3, IO4). As described through reference to FIG. 1, while four IO communication paths are depicted, it should be appreciated that any number of IO communication paths may be provided. The IO communication paths IO1-IO4 may allow for the routing of signals between various monitoring/control devices 203A, 203B, 203C and circuitry (not depicted) that may be associated with equipment that is controlled or monitored by the monitoring/control devices 203A, 203B, 203C. While three monitoring/control devices 203A, 203B, 203C are depicted, it should be appreciated that any number of such devices may be provided. Further, while the following discussion may be presented in a context in which the monitoring/control devices 203A, 203B, 203C represent ASIC devices, it should be appreciated that embodiments of the disclosure are not limited to ASIC devices and that any suitable monitoring/control device capable of supporting functionality described herein is within the scope of this disclosure.

The IO communication paths IO1-IO4 may be connected to each of the ASICs 203A, 203B, 203C such that the ASICs are connected in parallel. Electromagnetic interference (EMI) and/or electromagnetic compatibility (EMC) filter(s) 202 may be provided to reduce or eliminate interference or noise from signals transmitted along the IO communication paths IO1-IO4. Signals may be received by each of the parallel connected ASICs 203A, 203B, 203C on one or more of the IO communication paths IO1-IO4. In various embodiments, the signals may be representative of one or more parameters or may be otherwise utilized to monitor or measure one or more parameters such as, for example, a voltage, a current, a thermocouple, and so forth. The parameter values that are sensed or monitored by the ASIC devices 203A, 203B, 203C may be communicated to respective processing units 207A, 207B, 207C via respective communication paths 206A, 206B, 206C. While three processing units 207A, 207B, 207C are shown, it should be appreciated that any number of processing units may be provided. For example, in certain embodiments, the processing units may be provided in one-to-one correspondence with the ASIC devices. In other embodiments, multiple ASIC devices may be communicatively coupled to a single processing unit.

The processing units 207A, 207B, 207C may include any suitable processing unit capable of accepting digital data as input, processing the input data based on stored computer-executable instructions, and generating output data. The processing units 207A, 207B, 207C may be configured to execute computer-executable instructions stored in one or more memories to cause various operations to be performed. The processing units 207A, 207B, 207C may include any suitable processor including, but not limited to, a central processing unit, a microprocessor, a Reduced Instruction Set Computer (RISC) microprocessor, a microcontroller, an FPGA, a system on a chip (SOC), and forth.

The illustrative architecture 200 depicted in FIG. 2 may provide greater redundancy than the illustrative architecture 100 depicted in FIG. 1. As previously described, according to the configuration of the illustrative architecture 200, each ASIC 203A, 203B, 203C may be communicatively coupled to a respective processing unit 207A, 207B, 207C via a respective communication path 206A, 206B, 206C. Each communication path 206A, 206B, 206C may be communicatively coupled to a respective isolation barrier (not shown) which may, in turn, route various signals between a respective processing unit and a respective ASIC. Each of the processing units 207A, 207B, 207C may be provided on a same processor board or on separate processor boards. Each processor board may include additional components such as any of those previously described through reference to the illustrative architecture depicted in FIG. 1.

A respective plurality of resistive elements are depicted in FIG. 1 as being associated with each ASIC. In various embodiments, each ASIC 203A, 203B, 203C may include one or more channels that may have respective operational modes assigned thereto. In the illustrative architecture 200 depicted in FIG. 2, each ASIC 203A, 203B, 203C may include two channels, with each channel having a corresponding resistive element associated therewith. For example, a resistive element 204A may be associated with a first channel of ASIC 203A and a resistive element 205A may be associated with a second channel of the ASIC 203A. Similarly, a resistive element 204B may be associated with a first channel of ASIC 203B and a resistive element 205B may be associated with a second channel of the ASIC 203B. In addition, a resistive element 204C may be associated with a first channel of ASIC 203C and a resistive element 205C may be associated with a second channel of the ASIC 203C. Each resistive element may be used for sensing various parameters such as input current. In certain embodiments, each ASIC 203A, 203B, 203C may have a respective one or more resistive elements dedicated to the ASIC device. However, in other embodiments, one or more resistive elements may be connected in parallel to multiple ASICs and shared across ASICs.

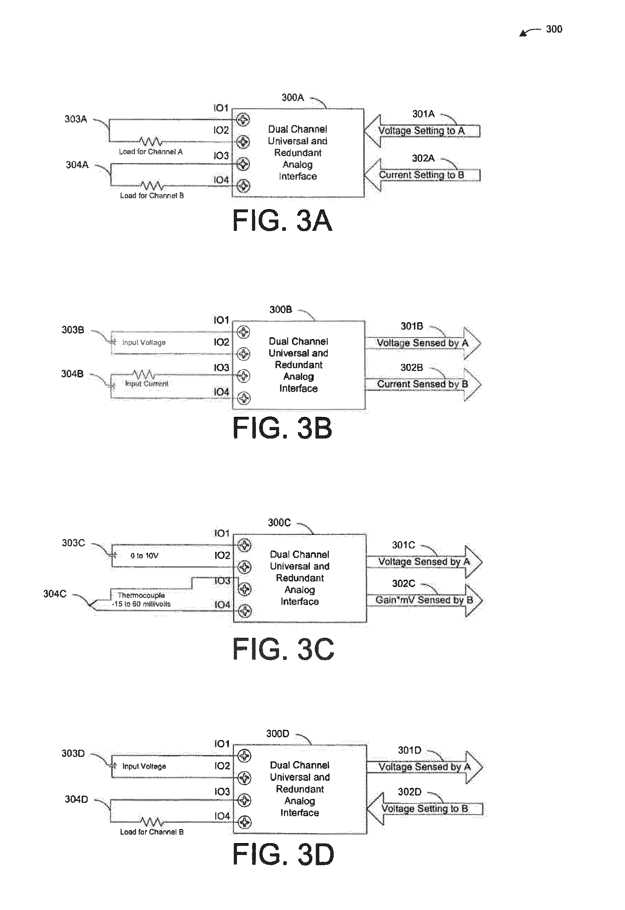

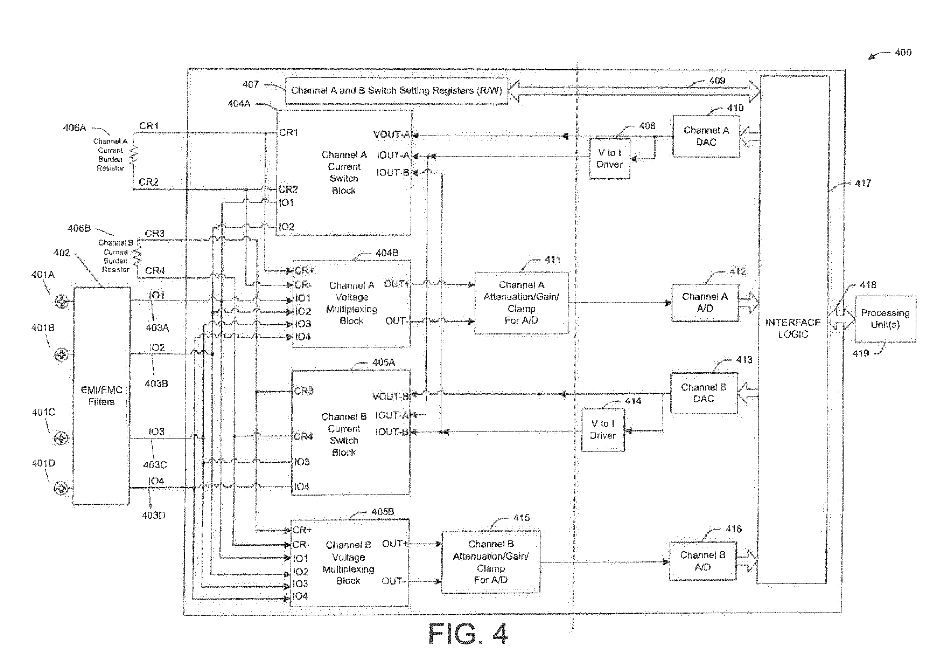

FIGS. 3A-3H depict schematic block diagrams illustrating various operational modes that may be assigned to channels of monitoring/control devices in accordance with one or more embodiments of the disclosure. The monitoring/control devices may be those depicted as part of the illustrative architectures shown in FIG. 1 or FIG. 2. The monitoring/control devices are depicted in FIGS. 3A-3H in abstracted form. Internal components of an illustrative monitoring/control device will be described in more detail through reference to FIG. 4. Further, although the illustrative monitoring/control devices shown in FIGS. 3A-3H are depicted as dual-channel devices, it should be appreciated that any number of channels may be provided. In addition, while particular parameters are depicted as being sensed from or particular parameter settings are depicted as being supplied to particular input/output communication paths, it should be appreciated that numerous variations in communication paths, sensed parameters, and/or parameter settings are within the scope of this disclosure.

FIG. 3A depicts an illustrative assignment of operational modes to channels of an illustrative monitoring/control device 300A. In the illustrative scenario depicted in FIG. 3A, a voltage setting 301A may be applied to a first channel of the device 300A and a current setting 302A may be applied to a second channel of the device 300A. A signal indicative of the voltage setting 301A may be transmitted from the device 300A (e.g., components associated with the first channel of the device 300A) via input/output communication paths IO1, IO2 to drive, for example, a respective load associated with the operation of equipment. Similarly, a signal indicative of the current setting 302A may be transmitted from the device 300A (e.g., components associated with the second channel of the device 300A) via input/output communication paths 103, IO4 to drive, for example, another respective load associated with the operation of equipment. The equipment may be controlled, for example, by a control system that supplies the voltage and current settings to the device 300A.

FIG. 3B depicts an illustrative assignment of operational modes to channels of an illustrative monitoring/control device 300B in accordance with one or more additional embodiments of the disclosure. In the illustrative configuration depicted in FIG. 3B, a voltage parameter value 301B may be sensed by components associated with a first channel of the device 300B and a current parameter value 302B may be sensed by components associated with a second channel of the device 300B. For example, an input voltage 303B may be sensed across a resistive element provided across input/output communications paths IO1, IO2 (e.g., a resistive element associated with the first channel). Similarly, an input current 304B may be sensed across a resistive element provided across input/output communication paths 103, IO4 (e.g., a resistive element associated with the second channel). A respective operational mode may be assigned to the first channel of the device 300B for sensing the input voltage 303B and a respective operational mode may be assigned to the second channel of the device 300B for sensing the input current 304B. The sensed voltage and current may be communicated from the device 300B to one or more processing units. As previously described, multiple devices may be provided that each communicate sensed voltage and/or current values to one or more processing units which may, in turn, apply a voting methodology to determine whether any of the sensed values are indicative of a fault.

In certain embodiments in which multiple parallel connected ASIC devices are provided, current may flow into and out of paralleled input terminals (e.g., a pair of input/output communication paths). One ASIC device may be set such that the current flows through a resistive element (e.g., a burden resistor) associated with the ASIC device in order generate a voltage reading. Other parallel connected ASIC devices may be set to sense a voltage drop with their associated resistive elements (e.g., burden resistors) disconnected. Further, in various embodiments, fault detection may be further improved by having the processing unit(s) direct a disconnection of a resistive element from an ASIC device and direct a connection of another resistive element associated with another ASIC device.

FIG. 3C depicts an illustrative assignment of operational modes to channels of an illustrative monitoring/control device 300C in accordance with one or more additional embodiments of the disclosure. In the illustrative scenario depicted in FIG. 3C, a voltage parameter value 301C may be sensed by components associated with a first channel of the device 300C and a thermocouple parameter value 302C may be sensed by components associated with a second channel of the device 300C. For example, an input voltage 303C may be sensed across a resistive element provided across input/output communications paths IO1, 102. In addition, a thermocouple 304C may be sensed using input/output communication paths IO3, IO4. A respective operational mode may be assigned to the first channel of the device 300C for sensing the input voltage 303C and a respective operational mode may be assigned to the second channel of the device 300C for sensing the thermocouple 304C.

The sensed voltage and thermocouple may be communicated from the device 300C to one or more processing units. As previously described, multiple devices may be provided that each communicate sensed voltage and/or thermocouple values to one or more processing units which may, in turn, apply a voting methodology to determine whether any of the sensed values are indicative of a fault. For example, when the thermocouple 304C is established, a particular voltage may be expected. If the sensed thermocouple value 302C deviates by a threshold amount from this expected voltage, a fault may be determined to exist.

FIG. 3D depicts an illustrative assignment of operational modes to channels of an illustrative monitoring/control device 300D in accordance with one or more additional embodiments of the disclosure. The illustrative configuration depicted in FIG. 3D is one in which a parameter is sensed using a first channel of the device 300D and a parameter value is set using a second channel of the device 300D. While particular illustrative parameters are shown, it should be appreciated that numerous variations of channel assignments for sensing or setting a variety of parameters are within the scope of this disclosure. Further, it should be appreciated that in any illustrative assignment of operational modes, the channels of an ASIC device may be independently set to sense or control any of a variety of parameters.

As depicted in FIG. 3D, a voltage parameter value 301D may be sensed by components associated with a first channel of the device 300D. More specifically, an input voltage 303D may be sensed across a resistive element provided across input/output communications paths IO1, IO2. In addition, a voltage setting 302D may be supplied to a second channel of the device 300D. A signal indicative of the voltage setting 302D may be transmitted from the device 300D (e.g., components associated with the second channel of the device 300D) via input/output communication paths 103, IO4 to drive, for example, a load associated with the operation of equipment. The equipment may be controlled, for example, by a control system that supplies the voltage setting 302D to the second channel of the device 300D. Numerous other variations are possible. For example, a current setting rather than a voltage setting may be provided to the second channel of the device 300D.

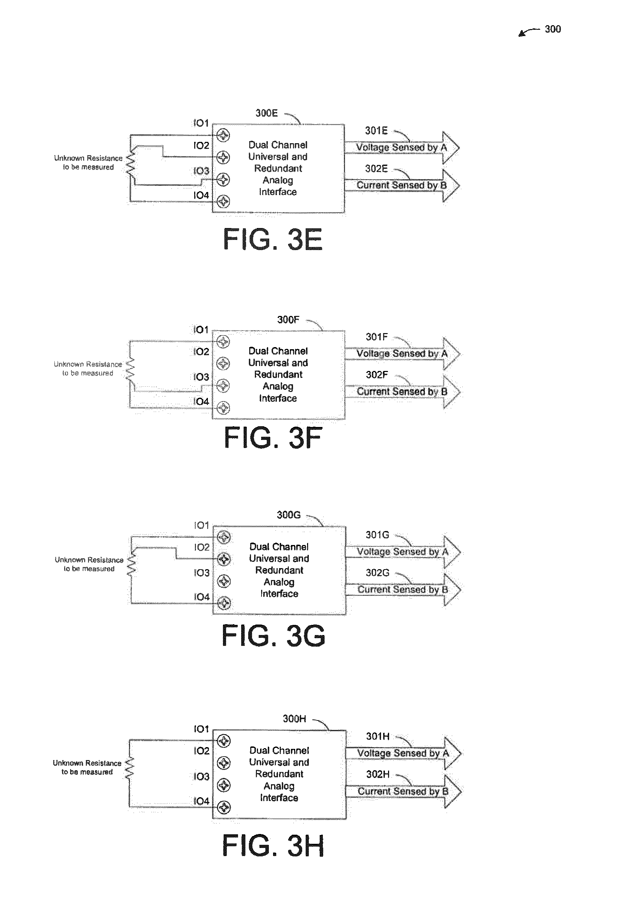

FIGS. 3E-3H depict schematic block diagrams illustrating various operational modes that may be assigned to channels of monitoring/control devices in order to measure an unknown resistance in accordance with one or more embodiments of the disclosure.

Each of the illustrative configurations depicted in FIGS. 3E-3H may utilize different input/output communication paths and/or a different number of communication paths to measure the unknown resistance.

FIG. 3E depicts an illustrative assignment of operational modes to channels of an illustrative monitoring/control device 300E in order to measure an unknown resistance in accordance with one or more embodiments of the disclosure. In the illustrative configuration depicted in FIG. 3E, a voltage parameter value 301E may be sensed by components associated with a first channel of the device 300E and a current parameter value 302E may be sensed by components associated with a second channel of the device 300E. As a non-limiting example, in the illustrative configuration depicted in FIG. 3E, a current may be applied across a resistive element using input/output communication paths IO1 and IO4. The current applied across the resistive element may be sensed by a burden resistor associated with, for example, a second channel of the device 300E. In addition, a voltage drop across the resistive element may be measured using input/output communication paths IO2 and IO3. In various embodiments, the unknown resistance may be determined based on a known proportional behavior of a resistance associated with the resistive element with another parameter. For example, the resistive element may have a resistance that changes according to a known proportional behavior with temperature or any other parameter.

FIG. 3F depicts another illustrative assignment of operational modes to channels of an illustrative monitoring/control device 300F in order to measure an unknown resistance in accordance with one or more additional embodiments of the disclosure. Similar to the configuration depicted in FIG. 3E, a voltage parameter value 301F may be sensed by components associated with a first channel of the device 300F and a current parameter value 302F may be sensed by components associated with a second channel of the device 300F. However, the illustrative configuration depicted in FIG. 3F differs from that depicted in FIG. 3E in that three of the input/output communication paths rather than four are used to measure the unknown resistance. For example, a current may be applied across a resistive element using input/output communication paths IO1 and 104. In addition, a voltage drop across the resistive element may be measured using input/output communication paths IO1 and 103. In this configuration, IO1 is used in connection with sensing of both current and voltage.

FIG. 3G depicts yet another illustrative assignment of operational modes to channels of an illustrative monitoring/control device 300G in order to measure an unknown resistance in accordance with one or more additional embodiments of the disclosure. Similar to the configurations depicted in FIGS. 3E and 3F, a voltage parameter value 301G may be sensed by components associated with a first channel of the device 300G and a current parameter value 302G may be sensed by components associated with a second channel of the device 300G. However, the illustrative configuration depicted in FIG. 3G differs from that depicted in FIG. 3E in that three of the input/output communication paths rather than four are used to measure the unknown resistance. Further, the illustrative configuration depicted in FIG. 3G differs from that depicted in FIG. 3F in that a different pair of input/output communication paths are used for the voltage measurement. For example, similar to the other depicted configurations, a current may be applied across a resistive element using input/output communication paths IO1 and 104. In addition, a voltage drop across the resistive element may be measured using input/output communication paths IO2 and 104. In this configuration, IO2 and IO4 are used in connection with the sensing of the voltage parameter value rather than IO1 and IO3 as depicted in FIG. 3F.

FIG. 3H depicts yet another illustrative assignment of operational modes to channels of an illustrative monitoring/control device 300H in order to measure an unknown resistance in accordance with one or more additional embodiments of the disclosure. Similar to the configurations depicted in FIGS. 3E, 3F and 3G, a voltage parameter value 301H may be sensed by components associated with a first channel of the device 300H and a current parameter value 302H may be sensed by components associated with a second channel of the device 300H. However, the illustrative configuration depicted in FIG. 3H differs from those depicted in FIGS. 3E, 3F and 3G in that two of the input/output communication paths rather than three (FIGS. 3F, 3G) or four (FIG. 3E) are used to measure the unknown resistance. For example, similar to the other depicted configurations, a current may be applied across a resistive element using input/output communication paths IO1 and IO4. In addition, a voltage drop across the resistive element may be measured using the same input/output communication paths IO1 and 104.

FIG. 4 is a detailed schematic block diagram depicting components of an illustrative monitoring/control device 400 in accordance with one or more embodiments of the disclosure. While the illustrative monitoring/control device 400 will be described in the context of an ASIC device, it should be appreciated that the following discussion is applicable to any suitable monitoring/control device configured to provide similar functionality. In addition, while the ASIC device 400 may be described as including particular components, it should be appreciated that some components may not be present and/or other components may be provided in various embodiments of the disclosure.

Input/output terminals 401A, 401B, 401C, 401D are shown in FIG. 4. The IO terminals 401A-401D may represent a communicative coupling of the ASIC device 400 with, for example, circuitry associated with equipment. Electromagnetic interference (EMI) and/or electromagnetic compatibility (EMC) filter(s) 402 may be provided to reduce or eliminate interference or noise from signals received from or transmitted to the IO terminals 401A-401D along input/output communication paths 403A, 403B, 403C, 403D (which may be referred to hereinafter respectively as IO1, 102, 103, 104). While four IO communication paths are depicted it should be appreciated that any number of IO paths may be provided. The IO communication paths IO1-IO4 may allow for routing of signals between the ASIC device 400 and circuitry (not depicted) that may be associated with equipment that is controlled or monitored by the ASIC device 400. For example, the circuitry may be associated with one or more sensors that detect various operational parameters of equipment, a control system that controls various operational parameters of equipment, and so forth.

The IO communication paths IO1-IO4 may be connected to each of multiple channels of the ASIC device 400. The ASIC device 400 is illustratively shown as including two channels (Channel A and Channel B). However, as previously noted, the ASIC device 400 may include any number of channels. A first channel (e.g., Channel A) may include a current switch block 404A and a voltage multiplexing block 404B. Similarly, a second channel (e.g., Channel B) may include a current switch block 405A and a voltage multiplexing block 405B. A particular pair of IO communication paths (e.g., IO1 and IO2) may be coupled to the current switch block 404A that forms part of the first channel of the ASIC device 400. Similarly, another pair of IO communication paths (e.g., IO3 and IO4) may be coupled to the current switch block 405A that forms part of the second channel of the ASIC device 400. Each of the IO communication paths IO1-IO4 may be coupled to the voltage multiplexing block 404B that forms part of the first channel of the ASIC device 400 as well as the voltage multiplexing block 405B that forms part of the second channel of the ASIC device 400.

Dedicated burden resistors 406A, 406B may be coupled to respective channels of the ASIC device 400. For example, burden resistor 406A may be provided that allows for current flow from the current switch block 404A of the first channel, through the burden resistor 406A, and back to the current switch block 404A. The current switch block 404A may also be coupled to the voltage multiplexing block 404B to provide for current flow between the current switch block 404A and the voltage multiplexing block 404B. Similarly, the burden resistor 406B may allow for current flow from the current switch block 405A of the second channel, through the burden resistor 406B, and back to the current switch block 405A. The current switch block 405A may also be coupled to the voltage multiplexing block 405B to provide for current flow between the current switch block 405A and the voltage multiplexing block 405B. It should be appreciated that while various connections between the communication paths IO1-IO4, the current switch blocks 404A, 405A, the voltage multiplexing blocks 404B, 405B, and the burden resistors 406A, 406B are illustratively shown in FIG. 4, numerous other connections and configurations are within the scope of this disclosure.

The ASIC device 400 may be configured to sense values indicative of one or more parameters such as, for example, values indicative of operating parameters associated with the operation of equipment. Further, the ASIC device 400 may be configured to receive parameter settings and communicate those settings to sensors or other circuitry associated with equipment to control the operation of the equipment. Signals indicative of parameter values sensed by the ASIC device 400 may be communicated from the voltage multiplexing block 404B forming part of the first channel of the ASIC device 400 to an attenuation or gain amplifier 411. The signals may then be communicated from the attenuation or gain amplifier 411 to an analog-to-digital converter (A/D 412) which converts the analog signals into digital signals and which may, in turn, communicate the digital signals to one or more processing units 419 via interface logic 418. Similarly, signals indicative of parameter values sensed by the ASIC device 400 may be communicated from the voltage multiplexing block 405B to an attenuation or gain amplifier 415. The signals may then be communicated from the attenuation or gain amplifier 415 to an analog-to-digital converter (A/D 416) which converts the analog signals into digital signals and which may, in turn, communicate the digital signals to the one or more processing units 419 via the interface logic 418. In addition, switch setting registers 407 may be provided. The switch setting registers 407 may facilitate switching of control between various channels of the ASIC device 400 such as, for example, when assigning operational modes to the channels. The switch setting registers 407 may be communicatively coupled to the processing unit(s) 419 via the interface logic 418 and may, in turn, be communicatively coupled to the interface logic 417 via a data communication path 409.

Various components may also be provided as part of the ASIC device 400 to facilitate the receipt of parameter settings by the ASIC device 400 from the processing unit(s) 419. For example, a digital-to-analog converter (DAC) 410 may be provided as part of or in association with a first channel of the ASIC device 400. The DAC 410 may receive a digital signal indicative of a voltage setting from the processing unit(s) 419, convert the digital signal to an analog signal, and communicate the analog signal to, for example, the current switch block 404A. A voltage-to-current (V to I) driver 408 may also be provided. The digital signal indicative of a voltage setting may be communicated to the V to I driver 408 which may, in turn, convert the signal to one indicative of a current setting and supply the converted signal to the current switch block 404A and the current switch block 405A.

Similar components may be provided as part of or in association with a second channel of the ASIC device 400. For example, a digital-to-analog converter (DAC) 413 may be provided as part of or in association with a first channel of the ASIC device 400. The DAC 413 may receive a digital signal indicative of a voltage setting from the processing unit(s) 419, convert the digital signal to an analog signal, and communicate the analog signal to, for example, the current switch block 405A. A voltage-to-current (V to I) driver 414 may also be provided. The digital signal indicative of a voltage setting may be communicated to the V to I driver 414 which may, in turn, convert the signal to one indicative of a current setting and supply the converted signal to the current switch block 405A and the current switch block 404A.

A dashed line is depicted in FIG. 4 to illustrate that in various embodiments some of the depicted components may be provided as part of the ASIC device 400 or externally to the device 400. For example, in various embodiments, the A/D 412 and/or the A/D 416 may be provided as part of the ASIC device 400 while, in other embodiments, the A/D 412 and/or the A/D 416 may be provided externally to the device 400. Similarly, the DAC 410 and/or the DAC 413 may be provided as part of the ASIC device 400 while, in other embodiments, the DAC 410 and/or the DAC 413 may be provided externally to the device 400. In addition, the V to I driver 408 may be provided as part of the DAC 410 or as a separate component, and thus, may form part of the device 400 or may be provided externally to the device 400. Similarly, the V to I driver 414 may be provided as part of the DAC 413 or as a separate component, and thus, may form part of the device 400 or may be provided externally to the device 400.

It should be appreciated that while an illustrative configuration of a monitoring/control device 400 in accordance with one or more embodiments of the disclosure is shown in FIG. 4, numerous other configurations that include fewer or more components and/or an alternative arrangement of such components are within the scope of this disclosure.

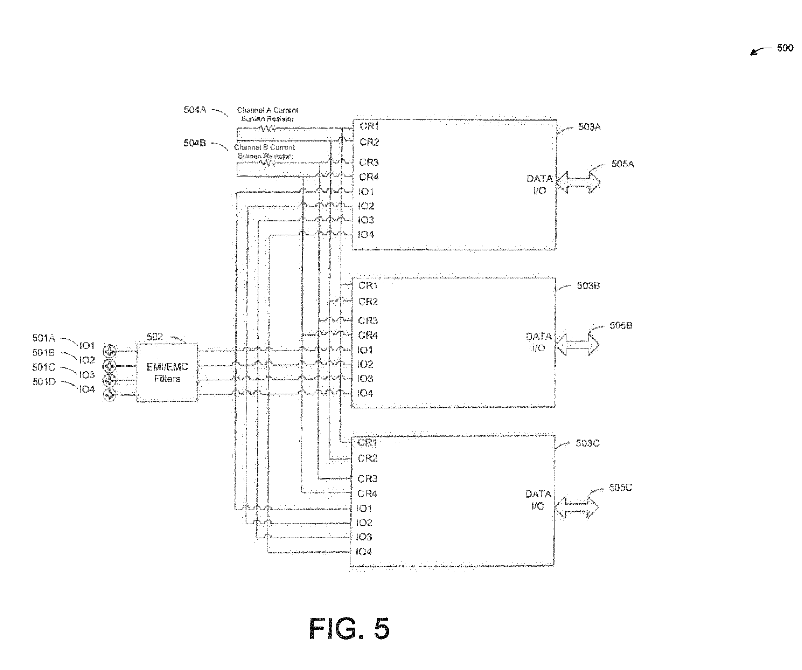

FIG. 5 is a schematic block diagram depicting an illustrative architecture for fault detection in accordance with one or more additional embodiments of the disclosure.

The illustrative architecture 500 differs from the architectures 100 and 200 respectively depicted in FIGS. 1 and 2 in that resistive elements (e.g., burden resistors 504A and 505A) are shared across multiple monitoring/control devices. The architecture 5 00 includes input/output communication paths 501A, 501B, 501C, 501D (which may be referred to hereinafter respectively as IO1, 102, 103, IO4 or collectively as IO1-IO4). While four IO communication paths are depicted it should be appreciated that any number of IO paths may be provided. As previously described through reference, for example to the illustrative architectures 100 and 200, the IO communication paths IO1-IO4 may allow for routing of signals between various monitoring/control devices 503A, 503B, 503C and circuitry (not depicted) that may be associated with equipment that is controlled or monitored by the monitoring/control devices 503A, 503B, 503C. Further, as previously described, while three monitoring/control devices 503A, 503B, 503C are depicted, it should be appreciated that any number of such devices may be provided. Further, while the following discussion may be presented in a context in which the monitoring/control devices 503A, 503B, 503C represent ASIC devices, it should be appreciated that embodiments of the disclosure are not limited to ASICs and that any suitable monitoring/control device capable of supporting functionality described herein is within the scope of this disclosure.

The IO communication paths IO1-IO4 may be connected to each of the ASICs 503A, 503B, 503C such that the ASICs are connected in parallel. Electromagnetic interference (EMI) and/or electromagnetic compatibility (EMC) filter(s) 502 may be provided to reduce or eliminate interference or noise from signals transmitted along the IO communication paths IO1-IO4. Various data communication paths 505A, 505B, 505C are also depicted in FIG. 5. Each of the data communication paths 505A, 505B, 505C may be a dedicated communication path associated with a respective one ASIC device of the ASIC devices 503A, 503B, 503C. Each dedicated data communication path may communicatively couple a respective ASIC device to a respective one or more processing units. In one or more alternative embodiments, each of the data communication paths 505A, 505B, 505C may be coupled to a shared data communication path that couples the ASIC devices 503A, 503B, 503C to one or more shared processing units.

In the illustrative architecture 500, resistive elements 504A, 504B may be shared across the multiple ASIC devices 503A, 503B, 503C, and thus the architecture 500 differs in this respect from the illustrative architectures 100 and 200 depicted in FIGS. 1 and 2, respectively, in which each ASIC device is associated with a respective plurality of resistive elements. In the illustrative architecture 500, each of the IO communication paths IO1-IO4 may be coupled to each of the ASIC devices 503A, 503B, 503C to provide a parallel connection between the ASIC devices 503A, 503B, 503C. One of the resistive elements (e.g., resistor 504A) may be used for sensing current based on an operational mode assigned to a first channel of an ASIC device. Another one of the resistive elements (e.g., resistor 504B) may be used for sensing current based on an operational mode assigned to a second channel of an ASIC device.

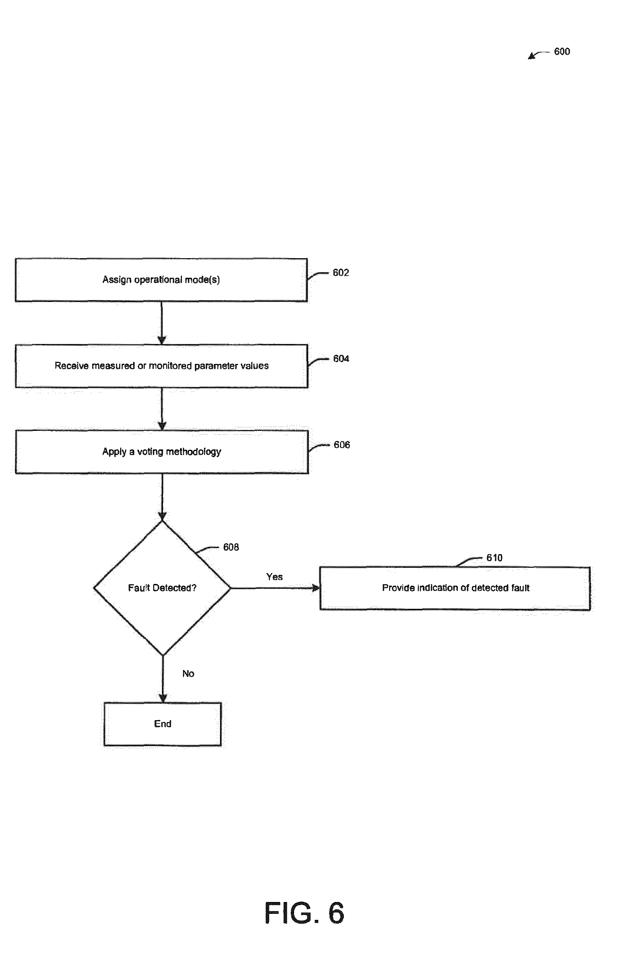

FIG. 6 is a process flow diagram depicting an illustrative method 600 for fault detection in accordance with one or more embodiments of the disclosure. The method 600 may begin at block 602 where one or more operational modes may be assigned to channels of one or more ASIC devices. For example, multiple ASIC devices may be connected in parallel and any of the illustrative operational modes depicted in FIGS. 3A-3H may be assigned to channels of the ASIC devices. In those embodiments in which an ASIC channel is supplied with a parameter setting (e.g., a voltage setting, a current setting, etc.) from one or more processing units, one of the parallel connected ASIC devices may be designated for converting the digital signal indicative of the parameter to be set to an analog signal and communicating the analog signal via various input/output communication paths to, for example, drive a load associated with equipment being monitored and controlled by the one or more processing units. In such embodiments, channels of other parallel connected ASIC devices may be assigned operational modes for monitoring or sensing the parameter value being set by the designated ASIC device. In other embodiments, a respective channel associated with each of the parallel connected ASIC devices may be assigned an operational mode for sensing a same parameter value received as input via various input/output communication paths. It should be appreciated that the above examples of types of channel assignments are merely illustrative and that numerous other variations in channel assignments are within the scope of this disclosure.

At block 604, measured or monitored parameter values may be received by the one or more processing units from the ASIC devices. In other embodiments, the measured or monitored parameter values may be received from one or more components provided externally to the ASIC devices such as, for example, in those embodiments in which DACs, A/Ds, and/or V to I converters are provided externally to the ASIC devices. The measured or monitored parameter values may be indicative of parameter values sensed by the ASIC devices and/or parameter values set by the processing units and communicated via the ASIC devices to control equipment operation.

At block 606, the processing unit(s) may analyze the received parameter values based on an appropriate voting methodology. More specifically, the processing unit(s) may compare each of the received values to an expected value to determine whether any of the values deviate from the expected value by more than a threshold amount. For example, if respective parameter values are received from two ASIC devices connected in parallel, the received values may be compared to historical values received from the devices to determine whether the received values deviate from historical values by more than a threshold amount. The threshold amount may be determined based on any number of factors including historical values received from the devices or any other suitable factors. In those embodiments in which more than two ASIC devices are connected in parallel and measured or monitored parameters are received from each of the devices, a median voting methodology may be employed. For example, a median value of the received values may be selected as the expected value and deviations of other received values from the median value may be determined and compared to a threshold deviation amount. In still other embodiments, such as for example when a parameter value is being set, the expected value may be the parameter setting value. It should be appreciated that any other suitable voting methodology including any suitable expected value is within the scope of this disclosure.

At block 608, a determination may be made as to whether a fault condition has been detected. More specifically, if any of the deviations identified based on application of the voting methodology at block 606 are determined to exceed a threshold deviation amount, it may be assumed that a fault condition has occurred.

At block 610, an indication of the detected fault condition may be provided to, for example, a workstation operator via any suitable interface such as a human-machine interface (HMI). Based on an assessment of the received values and the determined deviations, a nature of the fault condition may be determined. For example, in an illustrative configuration, a channel of a particular ASIC may be assigned an operational mode associated with a parameter value to be set. A value received from that ASIC may deviate from the parameter setting by more than a threshold amount and monitored values received from other ASIC devices connected in parallel to the driving ASIC device may also deviate from the expected value (e.g., the parameter setting) by more than the threshold amount. In such a scenario, it may be determined that the fault condition is associated with the driving ASIC device, and it may be further determined that an A/D component associated with the driving ASIC device is corrupted because of the deviation in the value received from the driving ASIC device and the expected value. It other embodiments, if all values received from the ASIC devices indicate a zero reading, this may not be indicative of a fault condition associated with any of the ASIC devices. Rather, it may be determined that, for example, an input/output communication path has been disconnected. It should be appreciated that numerous other scenarios may exist for determining the nature of the fault condition and/or the particular component(s) that may be corrupted and that such scenarios are within the scope of this disclosure. Further, in various embodiments, an indication of the fault condition may not be provided to an operation, but rather the processing unit(s) may employ one or more corrective measures based on one or more suitable algorithms.

Illustrative systems and methods for fault detection have been described. Some or all of these systems and methods may, but need not, be implemented at least partially by architecture(s) such as those shown in FIGS. 1-5. It should be appreciated that any of the elements or steps of any of the methods described herein need not be performed in the order described, may be rearranged or modified, and/or may be omitted entirely, depending on the circumstances. In addition, additional elements or steps may be introduced beyond those that have been described. Further, any of the elements or steps described above with respect to any method may be implemented by any number of processors or other programmable devices executing computer-executable instructions that may be stored on one or more computer-readable storage media.

Although embodiments have been described in language specific to structural features and/or methodological acts, it should be appreciated that the disclosure is not necessarily limited to the specific features or acts described. Rather, the specific features and acts are disclosed as illustrative implementations of the embodiments.

Various aspects and embodiments of the present invention are defined by the following numbered clauses:
1. A method, comprising:
   identifying, by at least one controller, a plurality of values, wherein each of the plurality of values corresponds to a respective one of: a monitored parameter or a measured parameter;
   determining, by the at least one controller, a respective deviation between each of the plurality of values and an expected value;
   determining, by the at least one controller, that at least one of the respective deviations exceeds a threshold; and
   detecting, by the at least one controller, a fault based at least in part on the determination that at least one of the respective deviations exceeds the threshold.
2. The method of clause 1, wherein each of the plurality of values is monitored or measured by a respective device of a plurality of devices.
3. The method of any preceding clause, wherein each device of the plurality of devices comprises at least one channel, further comprising:
   establishing, by the at least one controller, a respective operational mode for each at least one channel,
   wherein each operational mode is associated with a respective one of the plurality of values.
4. The method of any preceding clause, wherein each device of the plurality of devices comprises a respective application-specific integrated circuit (ASIC).
5. The method of any preceding clause, wherein the at least one controller comprises a processor communicatively coupled to each device of the plurality of devices via at least one shared communication path.
6. The method of any preceding clause, wherein the at least one controller comprises a processor communicatively coupled to each device of the plurality of devices via one or more respective separate communication paths.
7. The method of any preceding clause, wherein the at least one controller comprises a plurality of processors, and wherein each processor is communicatively coupled to a respective device of the plurality of devices via one or more separate communication paths.
8. The method of any preceding clause, wherein the each of the plurality of values corresponds to a respective signal received or outputted by at least one device of the plurality of devices via at least one input/output communication path shared with at least one other device of the plurality of devices.
9. The method of any preceding clause, wherein the fault is associated with one of the plurality of devices.
10. The method of any preceding clause, wherein the monitored parameter or the measured parameter comprises one of: a current parameter, a voltage parameter, a resistance parameter, or a thermocouple parameter.
11. The method of any preceding clause, wherein the plurality of values comprises an odd number of values, and wherein the expected value corresponds to a median value of the plurality of values.
12. A system comprising:
   at least one controller;
   at least one memory storing computer-executable instructions; and
   a plurality of devices communicatively coupled to the at least one controller,
   wherein the at least one controller is configured to access the at least one memory and to execute the computer-executable instructions to:
      identify a plurality of values, wherein each of the plurality of values is monitored or measured by a respective device of the plurality of devices, and wherein each of the plurality of values is associated with a respective one of: a monitored parameter or a measured parameter;
      determine a respective deviation between each of the plurality of values and an expected value;
      determine that at least one of the respective deviations exceeds a threshold; and
      detect a fault based at least in part on the determination that at least one of the respective deviations exceeds the threshold.
13. The system of any preceding clause, wherein each device of the plurality of devices comprises at least one channel, and wherein the at least one controller is further configured to:
   establish a respective operational mode for each at least one channel,
   wherein each operational mode is associated with a respective one of the plurality of values.
14. The system of any preceding clause, wherein each device of the plurality of devices comprises a respective application-specific integrated circuit (ASIC).
15. The system of any preceding clause, wherein the at least one controller comprises a processor communicatively coupled to each device of the plurality of devices via at least one shared communication path.
16. The system of any preceding clause, wherein the at least one controller comprises a processor communicatively coupled to each device of the plurality of devices via one or more respective separate communication paths.
17. The system of any preceding clause, wherein the at least one controller comprises a plurality of processors, and wherein each processor is communicatively coupled to a respective device of the plurality of devices via one or more separate communication paths.
18. The system of any preceding clause, wherein the fault is associated with one of the plurality of devices.
19. The system of any preceding clause, wherein the plurality of values comprises an odd number of values, and wherein the expected value corresponds to a median value of the plurality of values.
20. One or more computer-readable media storing computer-executable instructions that upon execution by one or more processors configure the one or more processors to perform operations comprising:
   identifying a plurality of values, wherein each of the plurality of values corresponds to a respective one of: a monitored parameter or a measured parameter;
   determining a respective deviation between each of the plurality of values and an expected value;
   determining that at least one of the respective deviations exceeds a threshold; and
   detecting a fault based at least in part on the determination that at least one of the respective deviations exceeds the threshold.

## Claims

1. A method, comprising:
identifying, by at least one controller (110), a plurality of values, wherein each of the plurality of values corresponds to a respective one of: a monitored parameter or a measured parameter;
determining, by the at least one controller (100), a respective deviation between each of the plurality of values and an expected value;
determining, by the at least one controller (110), that at least one of the respective deviations exceeds a threshold; and
detecting, by the at least one controller (110), a fault based at least in part on the determination that at least one of the respective deviations exceeds the threshold.

2. The method of claim 1, wherein each of the plurality of values is monitored or measured by a respective device of a plurality of devices (103A-C).

3. The method of claim 2, wherein each device of the plurality of devices (103A-C) comprises at least one channel, further comprising:
establishing, by the at least one controller (110), a respective operational mode for each at least one channel,
wherein each operational mode is associated with a respective one of the plurality of values.

4. The method of claim 2 or claim 3, wherein the each of the plurality of values corresponds to a respective signal received or outputted by at least one device of the plurality of devices (103A-C) via at least one input/output communication path shared with at least one other device of the plurality of devices.

5. The method of claim 2, 3 or 4, wherein the fault is associated with one of the plurality of devices (103A-C).

6. The method of any preceding claim, wherein the monitored parameter or the measured parameter comprises one of: a current parameter, a voltage parameter, a resistance parameter, or a thermocouple parameter.

7. The method of any preceding claim, wherein the plurality of values comprises an odd number of values, and wherein the expected value corresponds to a median value of the plurality of values.

8. A system comprising at least one processor (110) configured perform the method of any preceding claim.

9. A system comprising:
at least one controller (110);
at least one memory (112) storing computer-executable instructions; and
a plurality of devices (103A-C) communicatively coupled to the at least one controller (110),
wherein the at least one controller (110) is configured to access the at least one memory (103A-C) and to execute the computer-executable instructions to:
identify a plurality of values, wherein each of the plurality of values is monitored or measured by a respective device of the plurality of devices (103A-C), and wherein each of the plurality of values is associated with a respective one of: a monitored parameter or a measured parameter;
determine a respective deviation between each of the plurality of values and an expected value;
determine that at least one of the respective deviations exceeds a threshold; and
detect a fault based at least in part on the determination that at least one of the respective deviations exceeds the threshold.

10. The system of claim 8 or claim 9, wherein each device of the plurality of devices (103A-C) comprises at least one channel, and wherein the at least one controller is further configured to:
establish a respective operational mode for each at least one channel,
wherein each operational mode is associated with a respective one of the plurality of values.

11. The system of claim 8, 9 or 10, wherein each device of the plurality of devices (103A-C) comprises a respective application-specific integrated circuit (ASIC).

12. The system of any one of claims 8 to 11, wherein the at least one controller (110) comprises at least one of:
a processor communicatively coupled to each device of the plurality of devices (103A-C) via at least one shared communication path;
a processor communicatively coupled to each device of the plurality of devices (103A-C) via one or more respective separate communication paths, and
a plurality of processors, and wherein each processor is communicatively coupled to a respective device of the plurality of devices (103A-C) via one or more separate communication paths.

13. The system of any one of claims 8 to 12, wherein the fault is associated with one of the plurality of devices (103A-C).

14. The system of any one of claims 8 to 13, wherein the plurality of values comprises an odd number of values, and wherein the expected value corresponds to a median value of the plurality of values.

15. One or more computer-readable media storing computer-executable instructions that upon execution by one or more processors (110) configure the one or more processors (110) to perform operations comprising:
identifying a plurality of values, wherein each of the plurality of values corresponds to a respective one of: a monitored parameter or a measured parameter;
determining a respective deviation between each of the plurality of values and an expected value;
determining that at least one of the respective deviations exceeds a threshold; and
detecting a fault based at least in part on the determination that at least one of the respective deviations exceeds the threshold.
